# EUROPÄISCHE PATENTSCHRIFT

(11) **EP 1 320 118 B1**
(45) Veröffentlichungstag und Bekanntmachung des Hinweises auf die Patenterteilung: **27.12.2006**
(21) Anmeldenummer: 02026291.1
(22) Anmeldetag: 27.11.2002
(51) Int. Cl.: H01J 37/32

(54) **Reaktor zur beidseitig gleichzeitigen Beschichtung von Brillengläsern**
Reactor for simultaneously coating both sides of spectacle glasses
Réacteur pour le revêtement simultané des deux faces de verres de lunettes

(30) Priorität: 13.12.2001 DE 10161469
(43) Veröffentlichungstag der Anmeldung: 18.06.2003
(73) Patentinhaber: Schott AG, 55122 Mainz (DE)
(72) Erfinder: Bewig, Lars, Dr., 37581 Bad Gandersheim (DE); Küpper, Thomas, Bad Gandersheim (DE)
(74) Vertreter: Sawodny, Michael-Wolfgang

(56) Entgegenhaltungen:
- DE-A- 4 414 083
- US-A- 6 010 755
- US-A- 6 027 621

## Beschreibung

Zur Beschichtung von Substraten sind Beschichtungsreaktoren bekannt geworden, mit einem Bodenteil, einem Deckelteil sowie Seitenwänden, einer Zuführleitung für gasförmige Medien in das Innere des Beschichtungsreaktors sowie Mikrowellenfenstem zum Einkoppeln von HF-Energie oder Mikrowellenenergie, mit deren Hilfe im Inneren des Reaktors ein Plasma gezündet wird. Bei der Mikrowellenenergie handelt es sich bevorzugt um gepulste Mikrowellenenergie. Eine Vorrichtung sowie ein Verfahren zum Beschichten eines Substrates mit Hilfe gepulster Mikrowellenenergie ist beispielsweise in der DE 38 30 249 C2 offenbart.

Aus der DE 44 14 0831 A1 ist eine Vorrichtung zum Herstellen dünner Schichten auf Kunststoff-Substraten mittels Gasphasenabscheidung durch Niederdruckplasma mit zwei diametral einander gegenüberliegend angeordneten Quellen und einer Beschichtungskammer in der die Substrate zwischen den Wirkungsbereichen beider Quellen gehalten werden, bekannt geworden.

In der US 6, 010, 755 ist eine Beschichtungsvorrichtung für das Aufbringen von Schutzschichten auf eine magnetische Speichereinrichtung bekannt geworden, bei der ein ECR-Plasma in einer Vakuumkammer angeregt wird, wobei das ECR-Plasma von gegenüberliegenden Seiten eingekoppelt wird.

Nachteilig an allen Vorrichtungen gemäß dem Stand der Technik ist, dass inhomogene Schichten abgeschieden werden, insbesondere in den Randbereichen, die Beschichtungsbedingungen von zu beschichtendem Substrat zu beschichtendem Substrat variieren und damit nur schwer reproduzierbar waren und das Volumen derartiger Reaktoren relativ groß gewesen ist, so dass die Gaswechselzeiten und damit die Prozesszeiten relativ lange waren. Ein weiterer Nachteil der Vorrichtungen gemäß dem Stand der Technik lag darin, dass Schichtdickenschwankungen nicht vermieden werden konnten.

Aufgabe der Erfindung ist es somit, eine Vorrichtung zur Beschichtung von Substraten anzugeben, die die obengenannten Nachteile vermeidet.

Erfindungsgemäß wird die Aufgabe durch eine Vorrichtung gemäß Anspruch 1 gelöst, die sich dadurch auszeichnet, dass die Hohlleiter zum Einkoppeln von Mikrowellenenergie, Gaszufuhreinrichtung und die Einrichtung zum Evakuieren des Beschichtungsraumes koaxial zueinander angeordnet sind. Durch eine derartige koaxiale Anordnung in einer Art Rohrreaktor mit einer koaxialen Mikrowellen-Gas- und Vakuum-Ankopplung können Uniformitätsprobleme beim Beschichten vermieden werden. Ein weiterer Vorteil einer derartigen Anordnung besteht darin, dass sie mit einem relativ kleinen Reaktorvolumen auskommt, was unnötig lange Gaswechselzeiten und damit Prozesszeiten vermeidet.

Eine besonders einfache Ladbarkeit des Beschichtungsreaktors bzw. Beschichtungsraumes mit einem zu beschichtenden Substrat ergibt sich, wenn die Vorrichtung zum Beschichten von Substraten aus zwei Teilvorrichtungen mit je einem Hohlleiter zum Einkoppeln von Mikrowellenenergie, einer Gaszufuhreinrichtung sowie einer Einrichtung zum Evakuieren des Beschichtungsraumes ausgeführt ist und die erste und zweite Teilvorrichtung gegeneinander verfahrbar sind, wobei durch das Verfahren ein Beschichtungsraum geöffnet oder geschlossen werden kann. Der Beschichtungsraum selbst ist eine aus der Vorrichtung zum Beschichten von Substraten entnehmbare Einrichtung, die vorteilhafterweise zwei Anschlüsse für Gaszufuhr, sowie zwei Anschlüsse zum Evakuieren des Beschichtungsraumes und Mikrowellenfenster zum Einkoppeln von Mikrowellenenergie umfasst. Werden die beiden Teilvorrichtungen auseinandergefahren, so kann der Beschichtungsraum entnommen werden, außerhalb der Vorrichtung zum Beschichten von Substraten beladen, anschließend in die Vorrichtung zum Beschichten von Substraten eingesetzt, sodann die beiden Teilvorrichtungen geschlossen, der Beschichtungsraum evakuiert, Gas und Precursergas eingeleitet und das Plasma im Beschichtungsraum zur Beschichtung des außerhalb der Beschichtungsvorrichtung eingelegten Substrates gezündet werden. Wenn der Beschichtungsvorgang abgeschlossen ist, können die beiden Teilvorrichtungen wieder auseinandergefahren, der Beschichtungsraum herausgenommen und außerhalb der Beschichtungsvorrichtung der Beschichtungsreaktor entladen werden.

Ein derart auswechselbarer Beschichtungsraum hat den Vorteil, dass reproduzierbare Beschichtungsverhältnisse für jedes zu beschichtende Substrat vorliegen.

So können bei einem derartigen Beschichtungsraum die Mirkowellenfenster, die bevorzugt Teil des Beschichtungsraumes selber sind, vor jeder erneuten Beschichtung getauscht werden. Dies verhindert, dass wie im Stand der Technik die Mirkowellenfenster bei jeder Beschichtung mitbeschichtet werden, wodurch sich die Delektrizitätskonstante und damit die Beschichtungsbedingungen von Beschichtung zu Beschichtung ändern. Durch die Erfindung wird also erreicht, dass die Beschichtungsbedingungen reproduzierbar für jeden Beschichtungsprozess eines Brillenglases eingestellt werden können. Der Beschichtungsraum gemäß der Erfindung kann als Einmalraum, das heißt als Beschichtungsraum , der nach jeder erfolgten Beschichtung verworfen wird, ausgebildet sein. Alternativ kann vorgesehen sein, den Beschichtungsraum nach jeder Beschichtung zu reinigen, so dass eine sich auf den Mirkowellenfenstern niederschlagende Beschichtung nach jeder erfolgten Beschichtung entfernt wird.

Besonders bevorzugt ist es, wenn der Beschichtungsraum in einer Art Rohrform ausgeführt ist, wobei die erste und die zweite Gaszufuhreinrichtung sowie die erste und die zweite Einrichtung zum Evakuieren des Beschichtungsraumes einander gegenüberliegend angeordnet sind, und zwar bei einem rohrförmigen Beschichtungsraum vorwiegend koaxial zur Rohrachse. Ein rohrförmiger Beschichtungsraum hat den Vorteil, dass dieser rotationsförmig ist und dieselbe Symmetrie aufweist wie der zu beschichtende Gegenstand. Hierdurch wird eine besonders gleichförmige Beschichtung erzielt.

Die Erfindung ist aber nicht auf rohrförmige bzw. rotationssymmetrische Beschichtungsräume beschränkt, auch andere Geometrien sind möglich.

Bevorzugt wird als zu beschichtendes Substrat ein planes oder gewölbtes Substrat mit einem maximalen Durchmesser bzw. einer größten Kantenlänge des Substrates von 15 cm verwandt. In der Regel ist das zu beschichtende Substrat ein Brillen- oder ein Linsensubstrat.

Nachfolgend soll die Erfindung anhand der Figuren beispielhaft beschrieben werden. Es zeigen:
- Fig. 1: eine erfindungsgemäße Vorrichtung in auseinandergezogenem Zustand zum Beladen.
- Fig. 2: eine erfindungsgemäße Vorrichtung im beladenen Zustand zur Beschichtung eines Substrates.

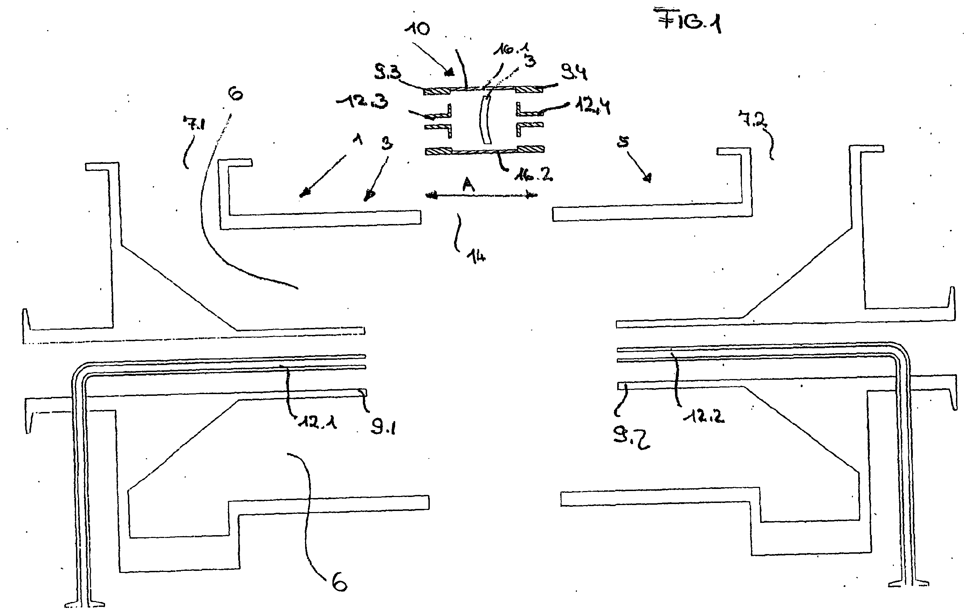

In Figur 1 ist eine erfindungsgemäße Vorrichtung 1 zum Beschichten eines Substrates 3, das vorliegend ein gewölbtes Substrat 3, beispielsweise ein Linsenoder ein Brillensubstrat, ist, gezeigt. Die Vorrichtung 1 besteht aus zwei Teilvorrichtungen 3, 5, die in Richtung der Rohrachse A verfahren werden kann.

Jede der beiden Teilvorrichtungen 3, 5 umfasst einen Hohlleiter 6 mit Öffnungen 7.1, 7.2 zum Einkoppeln von Mikrowellen- oder Hochfrequenzenergie von einem nicht dargestellten Mikrowellen- bzw. Hochfrequenzgenerator. Des weiteren weist jede der beiden Teilvorrichtungen einen rohrförmigen Vakuumanschluss 9.1, 9.2 auf. An den Vakuumanschluss wird zum einen der Beschichtungsreaktor 10, in den das zu beschichtende Substat 3 eingelegt wird, angeschlossen sowie eine Pumpe zum Evakuieren des Beschichtungsraumes 10. Die Pumpe zum Evakuieren des Beschichtungsraumes 10 ist vorliegend nicht dargestellt. Innerhalb des rohrförmigen Vakuumanschlusses verläuft koaxial zur Rohrachse je eine Gaszufuhrleitung 12.1.

Der Beschichtungsraum 10 ist wie der Vakuumanschluss 9.1, 9.2 im wesentlichen rohrförmig. Er kann durch die Öffnung 14 bei auseinandergezogenen Teilvorrichtungen, wie in Figur 1 gezeigt, in die Beschichtungsvorrichtung eingelegt werden. Der Beschichtungsraum 10 umfasst Anschlüsse 9.3 und 9.4, die mit den Vakuumanschlüssen 9.1 und 9.2 eine vakuumdichte Verbindung ausbilden. Ebenso umfasst der Beschichtungsraum 10 zwei Gaszufuhranschlüsse 12.3 und 12.4, die bei eingelegtem Beschichtungsraum 10 mit den Gaszufuhrleitungen 12.1 und 12.2 ebenfalls eine vakuumdichte Verbindung ausbilden.

Die Mikrowellenenergie wird in den Beschichtungsraum 10 beispielsweise über Mikrowellenfenster 16.1 und 16.2 eingekoppelt.

Der Vorteil der vorliegenden Beschichtungsanlage liegt darin, das der Beschichtungsraum 10 entnommen werden kann. Dies lässt beispielsweise die Reinigung der nach jedem Beschichtungsprozess mitbeschichteten Mirkowellenfenster zu. Alternativ kann auch für jedes zu beschichtende Brillenglas ein neuer Beschichtungsraum verwandt werden. Auf diese Art und Weise können stets gleiche Beschichtungsbedingungen sichergestellt werden.

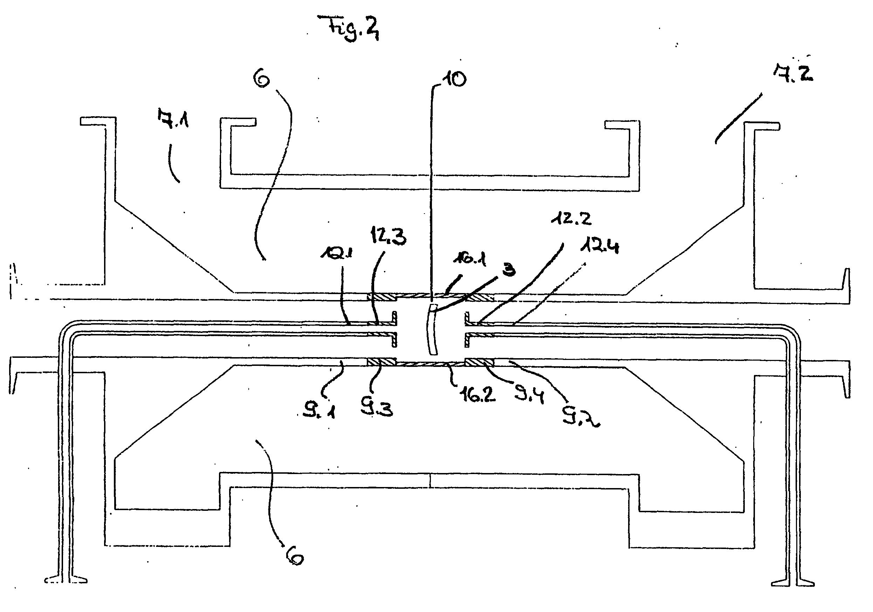

In Figur 2 ist die erfindungsgemäße Vorrichtung im beladenen Zustand, d.h. mit eingesetzter Beschichtungskammer 10 dargestellt. Gleiche Bauteile wie in Figur 1 sind mit denselben Bezugsziffern belegt. In Figur 10 ist deutlich zu erkennen, dass, wenn die beiden Teilvorrichtungen in koaxialer Richtung zusammengefahren werden, die Vakuumanschlüsse 9.3 und 9.4 der Beschichtungskammer 10 mit den Vakuumanschlüssen 9.1 und 9.2 der ersten und der zweiten Teilvorrichtung eine dichte Verbindung ausbilden, ebenso wie die Gaszufuhrleitungen 12.3 und 12.4 mit den Gaszufuhrleitungen 12.1 und 12.2 der ersten und zweiten Teilvorrichtung. Deutlich zu erkennen auch in Figur 2 die koaxiale Anordnung der Gaszufuhrleitung zum Vakuumanschluss. Wie in Figur 2 ebenfalls zu erkennen ist, enden die Gaszufuhrleitungen auf gegenüberliegenden Seiten des Substrates, so dass ein sehr gleichförmiges Einbringen des Gases in den Reaktorraum gewährleistet ist und hierdurch eine gegenüber dem Stand der Technik homogenere Beschichtung des Substrates gewährleistet wird.

Die Mikrowellenenergie wird über den Hohlleiter 6, mit den Öffnungen 7.1, 7.2 von einer außerhalb der Vorrichtung 1 gelegenen Mikrowellenquelle eingekoppelt. Der Hohlleiter 6 ist zum weitgehend rohrförmigen Vakuumanschluss 9.1, 9.2 und zur Beschichtungskammer koaxial angeordnet. Der Hohlleiter 6, in den die Mirkowellenenergie über die Öffnungen 7.1, 7.2 eingekoppelt wird kann wie der rohrförmige Beschichtungsraum 10, der auch als Beschichtungsreaktor bezeichnet wird, rotationssymmetrisch, bspw. als Rohr, das den Beschichtungsraum umgibt ausgeführt sein. Auch andere Ausgestaltungen sind möglich, ohne dass von der Erfindung abgewichen wird. Die über den Hohlleiter 6 in den Beschichtungsreaktor bzw. die Beschichtungskammer zugeführte Mikrowellenenergie wird über Mikrowellenfenster 16.1, 16.2 in den Beschichtungsraum 10, in dem sich das Substrat 3 befindet, eingekoppelt. Die Beschichtung erfolgt vorzugsweise mittels PICVD-Verfahren, wie beispielsweise in der DE 38 30 249 C2 offenbart. Bei diesem Verfahren wird zunächst über die Gaszufuhrleitungen 12.1, 12.2, 12.3 und 12.4 zunächst das Gas einer Gasatmosphäre und ein Precurser-Gas in das Innere des Beschichtungsreaktors 10 eingebracht. Sodann wird über eingekoppelte Energie, beispielsweise HF-Energie oder Mikrowellenenergie, im Innern des Beschichtungsreaktors 10 ein Plasma gezündet. In der vorliegenden Ausführungsform wird das Plasma mit Hilfe der über die Hohlleiterstruktur 6 zugeführte Mikrowellenenergie gezündet. Die über den Hohlleiter 6 zugeführte Mikrowellenenergie wird über die elektrischen Fenster 16.1, 16.2 in das Reaktorinnere eingekoppelt. Bei der Mikrowellenenergie handelt es sich, wie oben beschrieben, um gepulste Mikrowellenenergie. Der Vorteil eines gepulsten Plasmas liegt in der wesentlich niedrigeren Wärmebelastung des zu beschichtenden Substrates, das vorzugsweise ein Kunststoffmaterial ist. Daneben erlaubt die Anregung des Plasmas durch gepulste Mikrowellenstrahlung eine Beschichtung mit Wechselschichten oder Gradientenschichten, wie beispielsweise in der US 5,736,207 offenbart. Die in das Innere des dreidimensionalen Hohlkörpers bzw. des Reaktors eingeleiteten Precurser-Gase können beispielsweise HMDSN, HMDSO oder TiCl₄ umfassen. Als Gasatmosphäre ist eine O₂-Atmosphäre, eine N₂-Atmosphäre oder eine N₂ + NH₃-Atmosphäre denkbar. Mit Hilfe des gepulsten Plasmas kann das Substrat allseitig mit einer Beschichtung wie beispielsweise einer SiOₓ-, einer TᵢOₓ- oder einer Si0ₓoder einer SiₓN_{y} - Beschichtung, bevorzugt mit einer Dicke im Bereich 10 - 10000 nm, versehen werden. Mit der erfindungsgemäßen Vorrichtung ist es erstmals möglich, ein Substrat möglichst homogen bei optimiertem Volumen, das mit Gas zu befüllen ist, zu beschichten.

## Patentansprüche

1. Vorrichtung zum Beschichten von Substraten mit
1.1 einer ersten Teilvorrichtung (3), umfassend einen ersten Hohlleiter (6) zum Einkoppeln von Mikrowellenenergie, einer erste Gaszufuhreinrichtung (12.1) sowie einer ersten Einrichtung zum Evakuieren (9.1) eines Beschichtungsraumes;
1.2 einer zweiten Teilvorrichtung (5), umfassend einen zweiten Hohlleiter (6) zum Einkoppeln von Mikrowellenenergie, eine zweite Gaszufuhrleitung (12.2) sowie eine zweite Einrichtung zum Evakuieren (9.2) eines Beschichtungsraumes, wobei
1.3 erste und zweite Teilvorrichtung (3, 5) gegeneinander verfahrbar sind, wobei durch das Verfahren der Beschichtungsraum geöffnet und geschlossen werden kann, in den das zu beschichtende Substrat (3) eingebracht wird, **dadurch gekennzeichnet, dass**
1.4 der erste Hohlleiter (6) zum Einkoppeln von Mikrowellenenergie, die erste Gaszufuhreinrichtung (12.1) und die erste Einrichtung zum Evakuieren (9.1) des Beschichtungsraumes sowie der zweite Hohlleiter (6) zum Einkoppeln von Mikrowellenenergie, die zweite Gaszufuhreinrichtung (12.2) und die zweite Einrichtung zum Evakuieren (9.1) des Beschichtungsraumes jeweils koaxial zueinander angeordnet sind und der Beschichtungsraum derart ausgebildet ist, dass es aus der Vorrichtung entnehmbar und einsetzbar ist.

2. Vorrichtung gemäß Anspruch 1, **dadurch gekennzeichnet, dass** der Beschichtungsraum je einen Anschluss für die erste und die zweite Gaszufuhreinrichtung sowie einem Anschluss für die erste und die zweite Einrichtung zum Evakuieren des Beschichtungsraumes und Mikrowellenfenstern zum Einkoppeln von Mikrowellenenergie aus dem ersten und dem zweiten Hohlleiter umfasst.

3. Vorrichtung gemäß einem der Ansprüche 1 oder 2, **dadurch gekennzeichnet, dass** die erste und die zweite Gaszufuhreinrichtung und die erste und die zweite Einrichtung zum Evakuieren des Beschichtungsraumes einander gegenüberliegen.

4. Vorrichtung gemäß einem der Ansprüche 1 bis 3, **dadurch gekennzeichnet, dass** sie im Stande ist ein planes oder ein gewölbtes Substrat zu beschichten.

5. Vorrichtung gemäß Anspruch 1, **dadurch gekennzeichnet, dass** die Vorrichtung fähig ist Substrate mit einem Durchmesser bzw. größten Kantenlänge von 15 cm zu beschichten.

6. Vorrichtung gemäß einem der Ansprüche 1 bis 5, **dadurch gekennzeichnet, dass** sie fähig ist, ein Brillen- oder Linsensubstrat zu beschichten.

7. Verfahren zur beidseitigen, gleichmäßigen Beschichtung eines Substrates mit einer Vorrichtung gemäß einem der Ansprüche 1 bis 6, umfassend folgende Schritte:
7.1 in einen Beschichtungsraum wird ein Substrat eingebracht;
7.2 der Beschichtungsraum wird in die Vorrichtung zum Beschichten von Substraten eingelegt;
7.3 die beiden Teilvorrichtungen der Vorrichtung zum Beschichten von Substraten werden geschlossen;
7.4 der Beschichtungsraum wird evakuiert und
7.5 über die Gaszufuhreinrichtung ein Gas einer Gasatmosphäre sowie ein Precursergas in den Beschichtungsraum eingeleitet und ein Plasma durch Einkoppeln von gepulster Mikrowellenenergie gezündet, so dass das Substrat allseitig homogen beschichtet wird;
7.6 nach Abschluss des Beschichtungsvorganges wird das zu beschichtende Substrat entnommen.

8. Verwendung einer Vorrichtung gemäß einem der Ansprüche 1 bis 6 zur Beschichtung von Brillensubstraten.

9. Verwendung einer Vorrichtung gemäß einem der Ansprüche 1 bis 6 zur Beschichtung von Linsensubstraten.

## Claims

1. An apparatus for coating substrates, comprising
1.1 a first partial apparatus (3), comprising a first hollow conductor (6) for injecting microwave energy, a first gas supply device (12.1) and a first device for evacuating (9.1) a coating chamber;
1.2 a second partial apparatus (5), comprising a second hollow conductor (6) for injecting microwave energy, a second gas supply line (12.2) and a second device for evacuating (9.2) a coating chamber, with
1.3 the first and second partial apparatuses (3, 5) being movable relative to each other, with the coating chamber being capable of being opened and closed by the method, in which the substrate (3) to be coated is introduced, **characterized in that**
1.4 the first hollow conductor (6) for injecting microwave energy, the first gas supply device (12.1) and the first device for evacuating (9.1) of the coating chamber, and the second hollow conductor (6) for injecting microwave energy, the second gas supply device (12.2) and the second device for evacuating (9.1) the coating chamber are arranged coaxially with respect to each other and the coating chamber is configured in such a way that it can be removed from the apparatus and can be inserted again.

2. An apparatus according to claim 1, **characterized in that** the coating chamber comprises a connection each for the first and second gas supply device and a connection for the first and second device for evacuating the coating chamber and microwave windows for injecting microwave energy from the first and second hollow conductor.

3. An apparatus according to one of the claims 1 or 2, **characterized in that** the first and second gas supply device for evacuating the coating chamber are opposite of each other.

4. An apparatus according to one of the claims 1 to 3, **characterized in that** it is capable of coating a planar or curved substrate.

5. An apparatus according to claim 1, **characterized in that** the apparatus is capable of coating substrates with a diameter or largest edge length of 15 cm.

6. An apparatus according to one of the claims 1 to 5, **characterized in that** it is capable of coating a spectacle or lens substrate.

7. A method for evenly coating a substrate on both sides with an apparatus according to one of the claims 1 to 6, comprising the following steps:
7.1 a substrate is introduced into a coating chamber;
7.2 the coating chamber is inserted into the apparatus for coating substrates;
7.3 the two partial apparatuses of the apparatus for coating of substrates are closed;
7.4 the coating chamber is evacuated, and
7.5 a gas of a gas atmosphere is introduced via the gas supply device and a precursor gas is introduced into the coating chamber and a plasma is ignited by injecting pulsed microwave energy, so that the substrate is coated on all sides in a homogeneous manner;
7.6 the coated substrate is removed after the completion of the coating process.

8. The use of an apparatus according to one of the claims 1 to 6 for coating spectacle substrates.

9. The use of an apparatus according to one of the claims 1 to 6 for coating lens substrates.

## Revendications

1. Dispositif pour l'enduction de substrats, avec
1.1 un premier sous-ensemble (3) comprenant un premier guide d'ondes creux (6) destiné à amener de l'énergie sous forme de micro-ondes, un premier dispositif d'arrivée de gaz (12.1) et un premier dispositif pour faire le vide (9.1) dans une chambre d'enduction ;
1.2 un deuxième sous-ensemble (5) comprenant un deuxième guide d'ondes creux (6) destiné à amener de l'énergie sous forme de micro-ondes, une deuxième conduite d'arrivée de gaz (12.2) et un deuxième dispositif pour faire le vide (9.2) dans une chambre d'enduction ;
dans lequel
1.3 le premier sous-ensemble et le deuxième (3, 5) peuvent être déplacés l'un vers l'autre, ce déplacement ouvrant et fermant la chambre d'enduction dans laquelle le substrat (3) à enduire est déposé,
**caractérisé en ce que**
1.4 le premier guide d'ondes creux (6) destiné à amener de l'énergie sous forme de micro-ondes, le premier dispositif d'arrivée de gaz (12.1) et le premier dispositif pour faire le vide (9.1) dans la chambre d'enduction ainsi que le deuxième guide d'ondes creux (6) destiné à amener de l'énergie sous forme de micro-ondes, le deuxième dispositif d'arrivée de gaz (12.2) et le deuxième dispositif pour faire le vide (9.1) dans la chambre d'enduction sont disposés de façon coaxiale les uns par rapport aux autres et la chambre d'enduction est conformée de telle sorte qu'elle peut être retirée du dispositif et introduite dans celui-ci.

2. Dispositif selon la revendication 1, **caractérisé en ce que** la chambre d'enduction possède un raccord pour le premier dispositif d'arrivée de gaz et un pour le deuxième, ainsi qu'un raccord pour le premier dispositif pour faire le vide dans la chambre d'enduction et le deuxième et des fenêtres à micro-ondes pour transmettre l'énergie sous forme de micro-ondes à partir du premier guide d'ondes creux et du deuxième.

3. Dispositif selon l'une quelconque des revendications 1 ou 2, **caractérisé en ce que** le premier dispositif d'arrivée de gaz et le deuxième, ainsi que le premier dispositif pour faire le vide dans la chambre d'enduction et le deuxième se font face.

4. Dispositif selon l'une quelconque des revendications 1 à 3, **caractérisé en ce qu'**il peut enduire un substrat plan ou incurvé.

5. Dispositif selon la revendication 1, **caractérisé en ce qu'**il peut enduire des substrats ayant un diamètre ou une plus grande longueur de côté de 15 cm.

6. Dispositif selon l'une quelconque des revendications 1 à 5, **caractérisé en ce qu'**il peut enduire un substrat de lunettes ou de lentille.

7. Procédé pour l'enduction uniforme sur deux faces d'un substrat à l'aide d'un dispositif selon l'une quelconque des revendications 1 à 6, comprenant les étapes suivantes :
7.1 introduction d'un substrat dans la chambre d'enduction ;
7.2 insertion de la chambre d'enduction dans le dispositif pour l'enduction de substrats ;
7.3 fermeture des deux sous-ensembles du dispositif pour l'enduction de substrats ;
7.4 établissement d'un vide dans la chambre d'enduction et
7.5 introduction par le dispositif d'arrivée de gaz dans la chambre d'enduction d'un gaz d'atmosphère gazeuse et d'un gaz précurseur et allumage d'un plasma par application d'énergie sous forme d'impulsions de micro-ondes, de façon à enduire le substrat de façon homogène sur toutes les faces ;
7.6 retrait du substrat à enduire lorsque l'opération d'enduction est terminée.

8. Utilisation d'un dispositif selon l'une quelconque des revendications 1 bis 6 pour l'enduction de substrats de lunettes.

9. Utilisation d'un dispositif selon l'une quelconque des revendications 1 bis 6 pour l'enduction de substrats de lentilles.
